# EUROPEAN PATENT APPLICATION

(11) **EP 4 187 580 A1**
(43) Date of publication of application: **31.05.2023**
(21) Application number: 21863309.7
(22) Date of filing: 17.06.2021
(51) Int. Cl.: H01L 21/67

(54) **ION BEAM ETCHING MACHINE AND LIFTING AND ROTATING PLATFORM DEVICE THEREOF**

(30) Priority: 07.09.2020 CN 202010926525
(71) Applicant: Jiangsu Leuven Instruments Co. Ltd, Xuzhou, Jiangsu 221300 (CN)
(72) Inventor: LIU, Haiyang, Xuzhou, Jiangsu 221300 (CN); LIU, Xiaobo, Xuzhou, Jiangsu 221300 (CN); HU, Dongdong, Xuzhou, Jiangsu 221300 (CN); CHENG, Shiran, Xuzhou, Jiangsu 221300 (CN); GUO, Song, Xuzhou, Jiangsu 221300 (CN); ZHANG, Xiao, Xuzhou, Jiangsu 221300 (CN); XU, Kaidong, Xuzhou, Jiangsu 221300 (CN)
(74) Representative: dompatent von Kreisler Selting Werner - Partnerschaft von Patent- und Rechtsanwälten mbB
(86) International application number: PCT/CN2021/100680
(87) International publication number: WO 2022/048241

(57) **Abstract**

Disclosed are an ion beam etching machine and a lifting and rotating platform device thereof. The lifting and rotating platform device comprises a closed housing, a rotary shaft, a rotation driving unit, and a lifting driving unit. The closed housing comprises an upper housing, a lower housing, and a middle corrugated pipe. An upper end of the middle corrugated pipe is sealedly connected to the upper housing. A lower end of the middle corrugated pipe is sealedly connected to the lower housing. The rotary shaft passes through a shaft hole at an upper end of the upper housing. A dynamic seal is provided between the rotary shaft and the shaft hole. An object bearing platform is provided at an upper end of the rotary shaft located outside the closed housing. The rotation driving unit is mounted in the upper housing. The rotation driving unit is used to drive the rotary shaft to rotate within the shaft hole. The lifting driving unit is mounted in the lower housing. The lifting driving unit is used to drive the rotary shaft to ascend or descend in an axial direction. The rotary shaft, the upper housing, and the rotation driving unit ascend or descend synchronously. The present invention adjusts a distance between a wafer and a grid, such that the amount of etching in each diameter range of the wafer tends to be consistent, thereby optimizing the overall uniformity of the wafer.

## Description

### TECHNICAL FIELD

The present disclosure belongs to the technical field of semiconductor etching, and in particular to an ion beam etching machine as well as a lifting and rotating platform device thereof.

### BACKGROUND

The ion beam is drawn out from the ion beam etching machine through the grid. The grid consists of a screen grid, an accelerating grid and a decelerating grid. The grid structure is fixed, and the distance between the object bearing platform and the ion source grid is constant. In addition, the screen grid voltage of the grid in the ion beam etching machine is selected in the range of 50 V to 800 V according to the requirements, and the distribution and the uniformity of the etching rate of the wafer etched under different screen grid voltages are extremely different.

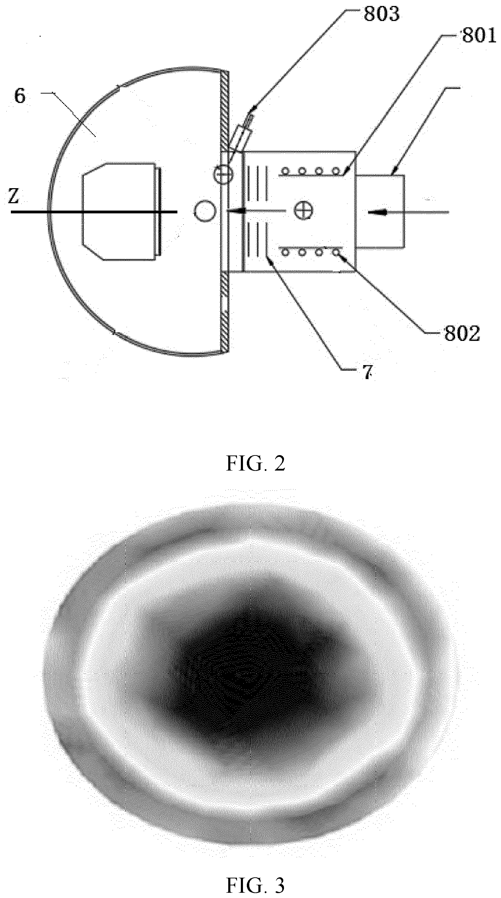

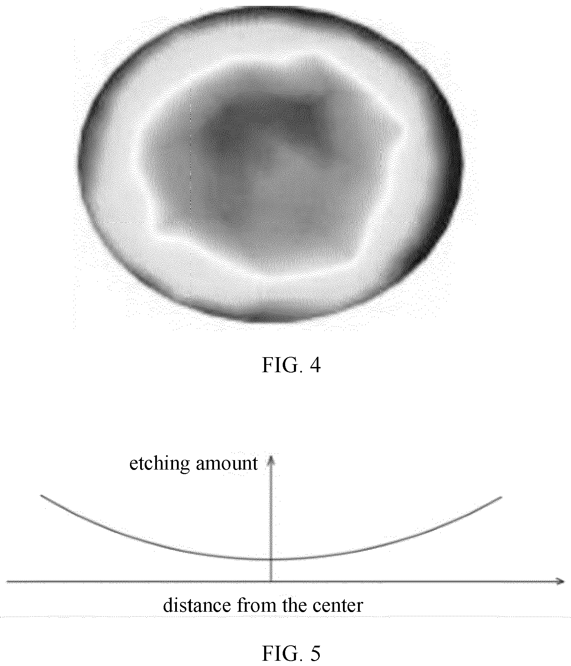

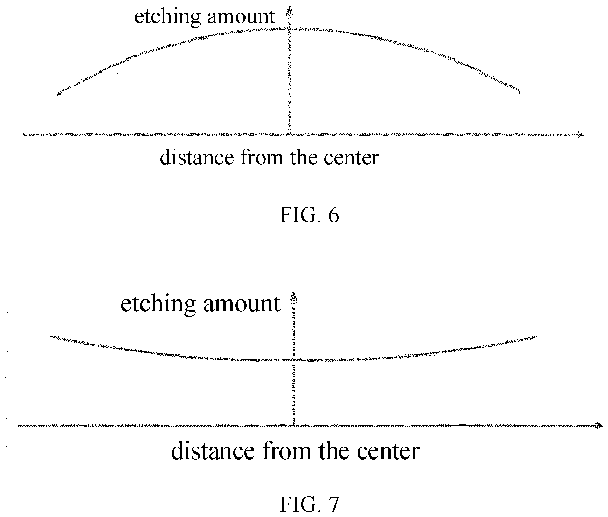

As the screen grid voltage of the grid increases, the energy of the ion beam drawn out from the ion source increases, the etching rate will increase, and the divergence angle of the ion beam drawn out from the grid increases. As illustrated in FIG. 3 that is a wafer graphic etched under a high voltage, it can be seen that the etching rate at the periphery is higher than that at the center, which results in a poor uniformity as illustrated in FIG. 5. Similarly, as the screen grid voltage of the grid decreases, the energy of the ion beam drawn out from the ion source decreases, the etching rate will decrease, and the divergence angle of the ion beam drawn out from the grid decreases. As illustrated in FIG. 4 that is a wafer graphic etched under a low voltage, it can be seen that the etching rate at the periphery is lower than that at the center, which also results in the poor uniformity as illustrated in FIG. 6.

In the prior art, the object bearing platform can only be rotated around its central axis to ensure good uniformity in the circumferential direction of the same radius of the wafer during the etching process, but cannot solve the above-mentioned problem of a poor uniformity in the radial direction.

### SUMMARY

In order to solve the above problems, an ion beam etching machine as well as a lifting and rotating platform device thereof are provided in the present disclosure, which can combine and adjust the distance between the wafer and the grid freely according to different processes, such that the amount of etching in each diameter range of the wafer tends to be consistent, and the overall uniformity of the wafer is optimized, especially the consistent and good uniformity can be obtained in different process conditions without replacing the chamber components, which greatly saves the cost of parts and improves the production efficiency.

Technical solutions are as follows: Provided in the present disclosure is a lifting and rotating platform device used in a vacuum etching chamber, which includes a closed housing, a rotating shaft, a rotating driving unit and a lifting driving unit.

The closed housing includes an upper housing, a lower housing and a middle corrugated pipe. The upper housing is located above the lower housing. An upper end of the middle corrugated pipe is sealedly connected to the upper housing. A lower end of the middle corrugated pipe is sealedly connected to the lower housing, and an upper end of the upper housing is provided with a shaft hole.

The rotating shaft is arranged through the shaft hole. A dynamic seal is arranged between the rotating shaft and the shaft hole. An object bearing platform configured to place a wafer is provided at an upper end of the rotating shaft located outside the closed housing. A first axial limiting mechanism is further arranged between the rotating shaft and the upper housing.

The rotating driving unit is mounted inside the upper housing. The rotating driving unit is configured to drive the rotating shaft to rotate along the shaft hole.

The lifting driving unit is mounted inside the lower housing. The lifting driving unit is configured to drive the rotating shaft to ascend or descend in an axial direction, and the rotating shaft and the upper housing are ascended or descended synchronously through the first axial limiting mechanism, and the rotating driving unit is ascended or descended synchronously along with the upper housing.

Further, the rotating driving unit is a hollow ring motor. A rotor of the hollow ring motor is fixedly connected to the rotating shaft. A stator of the hollow ring motor is fixedly connected to the upper housing, and the hollow ring motor serves as the first axial limiting mechanism between the rotating shaft and the upper housing.

Further, the lifting driving unit includes a rotating driving motor, a screw rod, and a nut slider. The screw rod is arranged along an ascending or descending direction of the rotating shaft. The nut slider is threadedly connected outside the screw rod. The rotating driving motor is mounted on the lower housing and configured to drive the screw rod to rotate. When the screw rod rotates, the nut slider is ascended or descended along the screw rod. A second axial limiting mechanisms is arranged between the nut slider and the rotating shaft, and the nut slider and the rotating shaft are ascended or descended synchronously through the second axial limiting mechanism.

Further, a lower end of the rotating shaft is provided with a guiding circular hole along the central axis. The second axial direction limiting mechanism includes a rolling bearing. An outer ring of the rolling bearing is fixedly connected to an inner wall of the guiding circular hole, and an inner ring of the rolling bearing is fixedly connected to the rotating shaft.

Further, the lifting driving unit further includes a first guiding sliding rod. The first guiding sliding rod is fixed on the lower housing. The first guiding sliding rod is arranged along the ascending or descending direction of the rotating shaft, and the nut slider is slidably sleeved outside the first guide sliding rod.

Further, the lifting driving unit is a linear driver. A main shaft of the linear driver is moved along the ascending or descending direction of the rotating shaft. The main shaft of the linear driver is connected to the upper housing or the main shaft to drive the upper housing, the rotating shaft and the rotating driving unit to ascend or descend synchronously.

Further, the closed housing further includes a plurality of second guiding sliding rods. The second guiding sliding rods are fixed on the lower housing, The second guide sliding rods are arranged along the ascending or descending direction of the rotating shaft, and the upper housing is slidably sleeved outside the second guiding sliding rods.

Further, the dynamic seal is a magnetic fluid sealing structure.

Provided is an ion beam etching machine, which includes a vacuum etching chamber, an ion source and a grid. Ions generated by the ion source are accelerated by the grid and enter the vacuum etching chamber to bombard a wafer, and the machine further includes the above mentioned lifting and rotating platform device.

Further, the ion source includes a quartz cylinder, a radio frequency coil and a neutralizer. One end of the quartz cylinder is in communication to the vacuum etching chamber, and another end of the quartz cylinder is in communication to a process gas for intaking. The grid is located between the one end of the quartz cylinder and the vacuum etching chamber. The radio frequency coil is located on an outer periphery of the quartz cylinder. The process gas enters through the other end of the quartz cylinder. The radio frequency coil is excited in the quartz cylinder to generate positive-charge plasmas, the positive-charge plasma is accelerated through the grid, electrons are released by the neutralizer, and the positive-charge plasmas after passing through the grid and the electrons are neutralized into neutral irons, and the neutral ions bombard the wafer on the lifting and rotating platform device.

Beneficial effects lie in the following. In the present disclosure, when in use, the rotating driving unit drives the rotating shaft to perform a circular motion around the central axis, so that the object bearing platform performs the circular motion. While the object bearing platform is in the circular motion, the lifting driving unit drives the upper housing, the rotating shaft and the rotating driving unit to ascend or descend synchronously. During the ascending or descending process of the upper housing, the elastic force of the middle corrugated pipe is released. The upper housing and the lower housing are connected with each other by the middle corrugated pipe to form a closed housing, which isolates the rotating driving unit and the lifting driving unit from the vacuum etching chamber to ensure the vacuum degree in the vacuum etching chamber.

The lifting and rotating platform device provided in the present disclosure can freely combine and adjust the distance between the wafer and the grid according to different processes, such that the amount of etching in each diameter range of the wafer tends to be consistent, and the overall uniformity of the wafer is optimized, especially the consistent and good uniformity can be obtained in different process conditions without replacing the chamber components, which greatly saves the cost of parts and improves production efficiency.

### BRIEF DESCRIPTION OF THE DRAWINGS

FIG. 1 illustrates a structural diagram of a lifting and rotating platform device used in a vacuum etching chamber of the present disclosure.
FIG. 2 illustrates a structural diagram of an ion beam etching machine in the present disclosure.
FIG. 3 illustrates a wafer graphic etched under a high voltage in the prior art.
FIG. 4 illustrates a wafer graphic etched under a low voltage in the prior art.
FIG. 5 illustrates a coordinate graphic of a wafer etching amount distribution under the high voltage in the prior art.
FIG. 6 illustrates a coordinate graphic of a wafer etching amount distribution under the low voltage in the prior art.
FIG. 7 illustrates a coordinate graphic of a wafer etching amount distribution etched by the ion beam etching machine in the present disclosure.

### DETAILED DESCRIPTION OF THE EMBODIMENTS

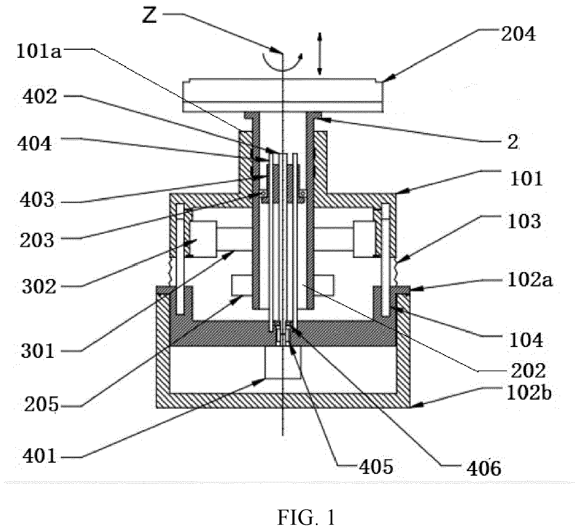

As illustrated in FIG. 1, a lifting and rotating platform device used in a vacuum etching chamber is provided in the present disclosure, which includes a closed housing, a rotating shaft 2, a rotating driving unit and a lifting driving unit.

The closed housing includes an upper housing 101, a lower housing and a middle corrugate pipe 103. The upper housing 101 is located above the lower housing. An upper end of the middle corrugate pipe 103 is sealedly connected to the upper housing 101. A lower end of the middle corrugate pipe 103 is sealedly connected to the lower housing. An upper end of the upper housing 101 is provided with a shaft hole 101a, and the shaft hole is arranged along a Z-axis.

The rotating shaft 2 is arranged through the shaft hole 101a. A dynamic seal is arranged between the rotating shaft 2 and the shaft hole 101a. Specifically, the dynamic seal is a magnetic fluid seal structure. In the magnetic fluid sealing structure, when the magnetic fluid is injected into a gap of the magnetic field, the magnetic fluid is capable of filling the entire gap to form a "liquid O-ring sealing" to ensure a high vacuum environment inside the chamber.

An object bearing platform 204 configured to place a wafer is provided at an upper end of the rotating shaft 2 located outside the closed housing. A first axial limiting mechanism is further arranged between the rotating shaft 2 and the upper housing 101.

The rotating driving unit is mounted inside the upper housing 101. The rotating driving unit is configured to drive the rotating shaft 2 to rotate along the shaft hole 101a. Specifically, the rotating driving unit is a hollow ring motor. A rotor 301 of the hollow ring motor is fixedly connected to the rotating shaft 2. The stator 302 of the hollow ring motor is fixedly connected to the upper housing 101, and the hollow ring motor serves as the first axial limiting mechanism between the rotating shaft 2 and the upper housing 101, which realizes an axial limiting between the rotating shaft 2 and the upper housing 101.

A common motor can also be selected in the rotating driving unit, which drives the rotating shaft 2 to rotate through a transmission mechanism such as a gear.

An encoder 205 is arranged on the rotating shaft 2, which can accurately monitor the rotating speed and position of the object bearing platform 204, and ensures the positional accuracy between the wafers.

The lifting driving unit is mounted inside the lower housing. The lifting driving unit is configured to drive the rotating shaft 2 to ascend or descend along the Z-axis. The rotating shaft 2 and the upper housing 101 are ascended or descended synchronously through the first axial limiting mechanism, and the rotating driving unit is ascended or descended synchronously along with the upper housing 101.

During the ascending or descending process of the upper housing 101, the elastic force of the middle corrugate pipe 103 is released. The upper housing 101 and the lower housing are connected with each other by the middle corrugate pipe 103 to form a closed housing, which isolates the rotating driving unit and the lifting driving unit from the vacuum etching chamber 6 to ensure the vacuum degree in the vacuum etching chamber 6.

The closed housing further includes a plurality of second guiding sliding rods 104. The second guiding sliding rods 104 are fixed on the lower housing. The second guiding sliding rods 104 are arranged along the ascending or descending direction of the rotating shaft 2. The upper housing 101 is slidably sleeved outside the second guiding sliding rods 104. The second guide sliding rods 104 plays a role of guiding the upper housing 101 to ascend or descend.

The lifting driving unit includes the following two embodiments.

Embodiment 1 is as follows. The lifting driving unit includes a rotating driving motor 401, a screw rod 402, and a nut slider 403. The screw rod 402 is arranged along the ascending or descending direction of the rotating shaft 2. The nut slider 403 is threadedly connected outside the screw rod 402. The rotating driving motor 401 is mounted on the lower housing, and is connected to the screw rod 402 through a coupling 405 to drive the screw rod 402 to rotate. When the screw rod 402 rotates, the nut slider 403 is ascended or descended along the screw rod 402. The second axial limiting mechanism is arranged between the nut slider 403 and the rotating shaft 2. The nut slider 403 and the rotating shaft 2 are ascended or descended synchronously through the second axial limiting mechanism. The lower housing is provided with a bearing 406 for supporting the screw rod 402.

The lower end of the rotating shaft 2 is provided with a guiding circular hole 202 along the central axis. The second axial limiting mechanism includes a rolling bearing 203. An outer ring of the rolling bearing 203 is fixedly connected to an inner wall of the guiding circular hole 202. An inner ring of the rolling bearing 203 is fixedly connected to the rotating shaft 2. The rolling bearing 203 plays an axial limiting role between the nut slider 403 and the rotating shaft 2, so that the nut slider 403 and the rotating shaft 2 are ascended or descended synchronously, and an additional torsion is not increased by rotating shaft 2 during the rotary motion process.

The lifting driving unit further includes a first guiding sliding bar 404. The first guiding sliding bar 404 is fixed on the lower housing. The first guiding sliding bar 404 is arranged along the ascending or descending direction of the rotating shaft 2. The nut slider 403 is slidably sleeved outside the first guide slide bar 404. The first guiding sliding bar 404 is capable of preventing the nut slider 403 from rotating, so that the nut slider 403 is ascended or descended along the screw rod 402.

The lower housing specifically includes a fixing seat 102a and a lower chamber cover 102b. An upper end surface of the fixing seat 102a is configured to mount the first guiding sliding bar 404, the second guiding sliding bar 104, the middle corrugate pipe 103 and the bearing 406. A lower end surface of the fixing seat 102a is configured to mount the rotating driving motor 401. The lower chamber cover 102b is sealedly connected with the fixing seat 102a, and is configured to seal the rotating driving motor 401.

Embodiment 2 is as follows. The lifting driving unit is a linear driver. A main shaft of the linear driver is moved along the ascending or descending direction of the rotating shaft 2, so that the main shaft of the linear driver is connected to the upper housing 101 or the main shaft to drive the upper housing 101, the rotating shaft 2 and the main shaft to ascend or descend synchronously. Preferably, the linear driver is mounted on the lower housing, and the main shaft is connected to the upper housing 101 to drive the upper housing 101, the rotating shaft 2 and the rotating driving unit to ascend or descend synchronously.

As illustrated in FIG. 2, an ion beam etching machine includes a vacuum etching chamber 6, an ion source and a grid 7, and further includes the above-mentioned lifting and rotating platform device 5.

The ion source includes a quartz cylinder 801, a radio frequency coil 802 and a neutralizer 803. One end of the quartz cylinder 801 is in communication to the vacuum etching chamber 6, and the other end of the quartz cylinder 801 is in communication to a process gas for intaking. The grid 7 is located between the one end of the quartz cylinder 801 and the vacuum etching chamber 6. The radio frequency coil 802 is located on an outer periphery of the quartz cylinder 801. The process gas enters from the other end of the quartz cylinder 801. The radio frequency coil 802 is excited in the quartz cylinder 801 to generate positive-charge plasmas. The positive-charge plasma is accelerated by the grid 7, electrons are released by the neutralizer 803, and the positive-charge plasmas after passing through the grid 7 and the electrons are neutralized into neutral ions, and the neutral ions bombard the wafer on the lifting and rotating platform device 5 .

In the present disclosure, when in use, the rotating driving unit drives the rotating shaft 2 to perform a circular motion around the central axis Z, so that the object bearing platform performs the circular motion. While the object bearing platform 204 is in the circular motion, the lifting driving unit drives the upper housing 101, the rotating shaft 2 and the rotating driving unit to ascend or descend synchronously. During the ascending or descending process of the upper housing 101, the elastic force of the middle corrugated pipe 103 is released. The upper housing 101 and the lower housing are connected with each other by the middle corrugated pipe 103 to form a closed housing, which isolates the rotating driving unit and the lifting driving unit from the vacuum etching chamber 6 to ensure the vacuum degree in the vacuum etching chamber 6.

The lifting and rotating platform device provided in the present disclosure can freely combine and adjust the distance between the wafer and the grid according to different processes. From an etching amount distribution graphic after optimizing the distance between the wafer and the grid as illustrated in FIG. 7, it can seen that the amount of etching in each diameter range of the wafer tends to be consistent, and the overall uniformity of the wafer is optimized, especially the consistent and good uniformity can be obtained in different process conditions without replacing the chamber components, which greatly saves the cost of parts and improves production efficiency.

## Claims

1. A lifting and rotating platform device used in a vacuum etching chamber, comprising a closed housing, a rotating shaft (2), a rotating driving unit and a lifting driving unit;
the closed housing includes an upper housing (101), a lower housing and a middle corrugate pipe (103), the upper housing (101) is located above the lower housing, an upper end of the middle corrugate pipe (103) is sealedly connected to the upper housing (101), a lower end of the middle corrugate pipe (103) is sealedly connected to the lower housing, an upper end of the upper housing (101) is provided with a shaft hole (101a);
the rotating shaft (2) is arranged through the shaft hole (101a), a dynamic seal is arranged between the rotating shaft (2) and the shaft hole (101a), an object bearing platform (204) configured to place a wafer is arranged at an upper end of the rotating shaft (2) located outside the closed housing, a first axial limiting mechanism is further arranged between the rotating shaft (2) and the upper housing (101);
the rotating driving unit is mounted inside the upper housing (101), the rotating driving unit is configured to drive the rotating shaft (2) to rotate along the shaft hole (101a); and the lifting driving unit is mounted inside the lower housing, the lifting driving unit is configured to drive the rotating shaft (2) to ascend or descend in an axial direction, the rotating shaft (2) and the upper housing (101) are ascended or descended synchronously through the first axial limiting mechanism, and the rotating driving unit is ascended or descended synchronously along with the upper housing (101).

2. The lifting and rotating platform device used in the vacuum etching chamber according to claim 1, wherein the rotating driving unit is a hollow ring motor, a rotor (301) of the hollow ring motor is fixedly connected to the rotating shaft (2), a stator (302) of the hollow ring motor is fixedly connected to the upper housing (101), and the hollow ring motor serves as the first axial limiting mechanism between the rotating shaft (2) and the upper housing (101).

3. The lifting and rotating platform device used in the vacuum etching chamber according to claim 1 or 2, wherein the lifting driving unit includes a rotating driving motor (401), a screw rod (402), and a nut slider (403); the screw rod (402) is arranged along an ascending or descending direction of the rotating shaft (2); the nut slider (403) is threadedly connected outside the screw rod (402); the rotating driving motor (401) is mounted on the lower housing and configured to drive the screw rod (402) to rotate; when the screw rod (402) rotates, the nut slider (403) is ascended or descended along the screw rod (402); a second axial limiting mechanisms is arranged between the nut slider (403) and the rotating shaft (2); and the nut slider (403) and the rotating shaft (2) are ascended or descended synchronously through the second axial limiting mechanism.

4. The lifting and rotating platform device used in the vacuum etching chamber according to claim 3, wherein a lower end of the rotating shaft (2) is provided with a guiding circular hole (202) along a central axis; the second axial direction limiting mechanism includes a rolling bearing (203), an outer ring of the rolling bearing (203) is fixedly connected to the inner wall of the guiding circular hole (202), and an inner ring of the rolling bearing (203) is fixedly connected to the rotating shaft (2).

5. The lifting and rotating platform device used in the vacuum etching chamber according to claim 4, wherein the lifting driving unit further includes a first guiding sliding rod (404), the first guiding sliding rod (404) is fixed on the lower housing, the first guiding sliding rod (404) is arranged along the ascending or descending direction of the rotating shaft (2), and the nut slider (403) is slidably sleeved outside the first guide sliding rod (404).

6. The lifting and rotating platform device used in the vacuum etching chamber according to claim 1 or 2, wherein the lifting driving unit is a linear driver, a main shaft of the linear driver is moved along the ascending or descending direction of the rotating shaft (2), the main shaft of the linear driver is connected to the upper housing (101) or the main shaft to drive the upper housing (101), the rotating shaft (2) and the rotating driving unit to ascend or descend synchronously.

7. The lifting and rotating platform device used in the vacuum etching chamber according to claim 1, wherein the closed housing further includes a plurality of second guiding sliding rods (104), the second guiding sliding rods (104) are fixed on the lower housing, the second guide sliding rods (104) are arranged along the ascending or descending direction of the rotating shaft (2), and the upper housing (101) is slidably sleeved outside the second guiding sliding rods (104).

8. The lifting and rotating platform device used in the vacuum etching chamber according to claim 1, wherein the dynamic seal is a magnetic fluid sealing structure.

9. An ion beam etching machine, comprising a vacuum etching chamber (6), an ion source and a grid (7), wherein ions generated by the ion source are accelerated by the grid (7) and enter the vacuum etching chamber (6) to bombard a wafer, and the machine further comprises a lifting and rotating platform device (5) according to any one of claims 1 to 8.

10. The ion beam etching machine according to claim 9, wherein the ion source includes a quartz cylinder (801), a radio frequency coil (802) and a neutralizer (803), one end of the quartz cylinder (801) is in communication to the vacuum etching chamber (6), and another end of the quartz cylinder (801) is in communication to a process gas for intaking, the grid (7) is located between the one end of the quartz cylinder (801) and the vacuum etching chamber (6), the radio frequency coil (802) is located on an outer periphery of the quartz cylinder (801), the process gas enters through the other end of the quartz cylinder (801), and the radio frequency coil (802) is excited in the quartz cylinder (801) to generate positive-charge plasmas, the positive-charge plasma is accelerated through the grid (7), electrons are released by the neutralizer (803), and the positive-charge plasmas after passing through the grid (7) and the electrons are neutralized into neutral irons, and the neutral ions bombard the wafer on the lifting and rotating platform device (5).
